# EUROPEAN PATENT APPLICATION

(11) **EP 4 769 886 A1**
(43) Date of publication of application: **01.07.2026**
(21) Application number: 25861080.7
(22) Date of filing: 10.07.2025
(51) Int. Cl.: H02J 7/00, H01M 10/42, H03K 17/687

(54) **BATTERY SYSTEM INCLUDING POWER SUPPLY UNIT AND OPERATING METHOD THEREOF**

(30) Priority: 02.09.2024 KR 20240118236
(71) Applicant: LG ENERGY SOLUTION, LTD., Seoul 07335 (KR)
(72) Inventor: HWANG, Jin Woo, Yuseong-gu, Daejeon 34122 (KR); KIM, Jaehwan, Yuseong-gu, Daejeon 34122 (KR); LEE, Jung Su, Yuseong-gu, Daejeon 34122 (KR); PARK, Mi So, Yuseong-gu, Daejeon 34122 (KR)
(74) Representative: BCKIP Part mbB
(86) International application number: PCT/KR2025/010073
(87) International publication number: WO 2026/049283

(57) **Abstract**

A battery system according to an embodiment of the present invention may comprise: a battery; a circuit breaker disposed on a charging/discharging line of the battery; and a battery management device for managing the battery and controlling the operation of the circuit breaker. Here, the battery management device may comprise: a control unit; a power supply unit which receives power from the battery through a first power supply line and supplies power to the control unit; and a power maintenance unit which receives power from the battery through a second power supply line and supplies temporary power to the power supply unit in a state in which the circuit breaker is open.

## Description

### [Technical Field]

This application claims priority to and the benefit of Korean Patent Application No.10-2024-0118236 filed in the Korean Intellectual Property Office on September 2, 2024 the entire contents of which are incorporated herein by reference.

The present invention relates to a battery system and an operating method thereof, and more particularly, to a battery system including a power supply unit that supplies power to a battery control apparatus and an operating method thereof.

### [Background Art]

Secondary batteries, capable of recharging and reuse, may be used as an energy source for small devices such as mobile phones, tablet PCs and vacuum cleaners, and also used as an energy source for medium and large devices such as automobiles and an energy storage system (ESS) for smart grids.

Secondary batteries may be applied to a system in a form of an assembly such as a battery pack in which multiple battery cells are electrically connected or a battery rack in which battery packs are electrically connected according to system requirements. For an ESS for smart grids, a high-capacity battery system with a plurality of battery racks connected in parallel can be applied to satisfy required capacity of the system.

Typically, a battery rack may include a Battery Protection Unit (BPU) to protect the battery from abnormal currents and fault currents. The BPU may include a circuit breaker (CB) to forcibly disconnect the electrical connection between the battery rack and the DC link, and a Rack Battery Management System (RBMS) to monitor and manage the battery packs.

The RBMS may also include a power supply unit (e.g., a Switching Mode Power Supply (SMPS)) that receives power from battery packs and supplies power to a Micro Controller Unit (MCU), communication modules, and other components.

If a hazardous situation occurs in the battery rack and the circuit breaker opens, the battery power supplied to the power supply unit is cut off. Consequently, the RBMS becomes turned off without properly performing a power-off sequence, including checking the state of internal components, storing data, and switching internal components to an OFF state.

Among the prior art documents relevant to the present invention, JP 2020-072596 A is of some relevance.

### [Detailed Description of the Invention]

### [Technical Problem]

To obviate one or more problems of the related art, embodiments of the present disclosure provide a battery system including a power holding unit that supplies temporary power to a power supply unit.

To obviate one or more problems of the related art, embodiments of the present disclosure also provide a method for operating the battery system.

To obviate one or more problems of the related art, embodiments of the present disclosure also provide a battery management apparatus included in the battery system.

### [Technical Solution]

In order to achieve the objective of the present disclosure, a battery system may include a battery; a circuit breaker located on a charge/discharge line of the battery; and a battery management apparatus configured to manage the battery and control the operation of the circuit breaker.

Here, the battery management apparatus may include a controller; a power supply unit configured to receive power from the battery through a first power supply line and supply power to the controller; and a power holding device configured to receive power from the battery through a second power supply line and to supply temporary power to the power supply unit in a state that the circuit breaker is open.

The controller may control the power holding device to activate the second power supply line upon a predefined circuit breaker open event occurring.

The controller may switch the circuit breaker to an open state after the second power supply line is activated and switches the second power supply line to an inactive state when a predetermined period of time has elapsed or a predetermined power-off sequence has been completed.

The first power supply line may have one end connected between the circuit breaker and a main contactor positioned on the charge/discharge line and the other end connected to a first power input terminal of the power supply unit.

The second power supply line may have one end connected between an output terminal of the battery and the circuit breaker and the other end connected to a second power input terminal of the power supply unit.

The power holding device may include a power holding switch disposed on the second power supply line. Here, the controller may switch the power holding switch from an open state to a closed state when a predefined circuit breaker open event occurs, thereby switching the second power supply line to an activated state.

The power holding device may include a MOSFET disposed on the second power supply line; a photocoupler that applies a gate voltage to the MOSFET; and a voltage supply switch disposed on a path that supplies an operating voltage to the photocoupler. Here, the controller switches the voltage supply switch from an open state to a closed state when a predefined circuit breaker open event occurs, thereby switching the second power supply line to an activated state.

The photocoupler may receive the operating voltage from the power supply unit.

According to another embodiment of the present disclosure, a method of operating a battery system may be performed by a battery management apparatus including a controller; a power supply unit configured to receive power from a battery through a first power supply line and supply power to the controller; and a power holding device configured to receive power from the battery through a second power supply line and supply temporary power to the power supply unit

The method of operating the battery system may include monitoring whether a predefined circuit breaker open event occurs; controlling the power holding device to switch the second power supply line from a deactivated state to an activated state if the circuit breaker open event occurs; and switching a circuit breaker disposed on a charge/discharge line of the battery to an open state after the second power supply line is activated.

The method of operating the battery system may further include switching the second power supply line to a deactivated state if a predetermined period of time has elapsed or a predetermined power-off sequence has been completed after the circuit breaker is switched to an open state.

The switching of the second power supply line from a deactivated state to an activated state may include switching a power holding switch disposed on the second power supply line from an open state to a closed state, thereby switching the second power supply line to an activated state.

The power holding device may include a MOSFET disposed on the second power supply line; a photocoupler that applies a gate voltage to the MOSFET; and a voltage supply switch disposed on a path that supplies an operating voltage to the photocoupler. Here, the switching of the second power supply line from a deactivated state to an activated state may include switching the voltage supply switch from an open state to a closed state, thereby switching the second power supply line to an activated state.

According to another embodiment of the present disclosure, a battery management apparatus, positioned between a circuit breaker disposed on a battery charge/discharge line and a DC link, may include a controller; a power supply unit configured to receive power from the battery through a first power supply line and supply power to the controller; and a power holding device configured to receive power from the battery through a second power supply line and to supply temporary power to the power supply unit in a state that the circuit breaker is open.

### [Advantageous Effects]

According to embodiments of the present disclosure, it is possible to maintain battery power supplied to a power supply device, even if the circuit breaker is switched to the open state, thereby allowing the battery system to be stably switched off.

### [Brief Description of the Drawings]

FIG. 1 is a block diagram of a general energy storage system.
FIG. 2 illustrates a structure of a general battery rack.
FIG. 3 is a block diagram of a battery system according to embodiments of the present invention.
FIG. 4 is a circuit diagram of a battery protection device according to embodiments of the present invention.
FIG. 5 is a circuit diagram of a power holding unit according to embodiments of the present invention.
FIG. 6 is a flowchart illustrating an operation method of a battery system according to embodiments of the present invention.
FIGS. 7 and 8 are reference diagrams for explaining an operation method of a battery system according to embodiments of the present invention.
FIG. 9 is a block diagram of a controller according to embodiments of the present invention.

100: battery protection device
110: battery management apparatus
111: controller
112: power supply unit
113: power holding unit
114: current sensor
120: circuit breaker
200: battery assembly
210: battery

### [Best Modes for Practicing the Disclosure]

The present invention may be modified in various forms and have various embodiments, and specific embodiments thereof are shown by way of example in the drawings and will be described in detail below. It should be understood, however, that there is no intent to limit the present invention to the specific embodiments, but on the contrary, the present invention is to cover all modifications, equivalents, and alternatives falling within the spirit and technical scope of the present invention. Like reference numerals refer to like elements throughout the description of the figures.

It will be understood that, although the terms such as first, second, A, B, and the like may be used herein to describe various elements, these elements should not be limited by these terms. These terms are only used to distinguish one element from another. For example, a first element could be termed a second element, and, similarly, a second element could be termed a first element, without departing from the scope of the present invention. As used herein, the term "and/or" includes combinations of a plurality of associated listed items or any of the plurality of associated listed items.

It will be understood that when an element is referred to as being "coupled" or "connected" to another element, it can be directly coupled or connected to the other element or an intervening element may be present. In contrast, when an element is referred to as being "directly coupled" or "directly connected" to another element, there is no intervening element present.

The terms used herein is for the purpose of describing specific embodiments only and are not intended to limit the present invention. As used herein, the singular forms "a", "an" and "the" are intended to include the plural forms as well, unless the context clearly indicates otherwise. It will be further understood that the terms "comprises", "comprising", "includes", "including" and/or "having", when used herein, specify the presence of stated features, integers, steps, operations, constitutional elements, components and/or combinations thereof, but do not preclude the presence or addition of one or more other features, integers, steps, operations, constitutional elements, components, and/or combinations thereof.

Unless otherwise defined, all terms used herein, including technical and scientific terms, have the same meanings as commonly understood by one skilled in the art to which the present invention belongs. It will be further understood that terms, such as those defined in commonly used dictionaries, should be interpreted as having meanings that are consistent with their meanings in the context of the relevant art and will not be interpreted in an idealized or overly formal sense unless expressly so defined herein.

Some terms used herein are defined as follows.

A battery cell is a basic unit that serves to store power and a battery module refers to an assembly in which a plurality of battery cells is electrically connected.

A battery rack may refer to a system of a single structure which is assembled by connecting module units set by a battery manufacturer in series/parallel and may be monitored and controlled by a battery management system (BMS). A battery rack may include several battery modules and a battery protection unit or any other protection device. Here, the battery module may also be referred to as a battery pack depending on a device or system in which the battery is used.

A battery bank refers to a group of large-scale battery rack systems configured by connecting a plurality of battery racks in parallel. A bank BMS for a battery bank may monitor and control several rack BMSs, each of which manages a battery rack.

A battery assembly may include a plurality of electrically connected battery cells, and refers to an assembly that functions as a power supply source by being applied to a specific system or device. Here, the battery assembly may mean a battery module, a battery pack, a battery rack, or a battery bank, but the scope of the present invention is not limited to these entities.

A battery system controller (BSC) refers to an apparatus that controls the topmost level of a battery system including a battery bank level structure or a multiple bank level structure.

State of Charge (SOC) refers to a current state of charge of a battery, represented in percent points [%], and State of Health (SOH) refers to a current condition of a battery compared to its ideal or original conditions, represented in percent points [%].

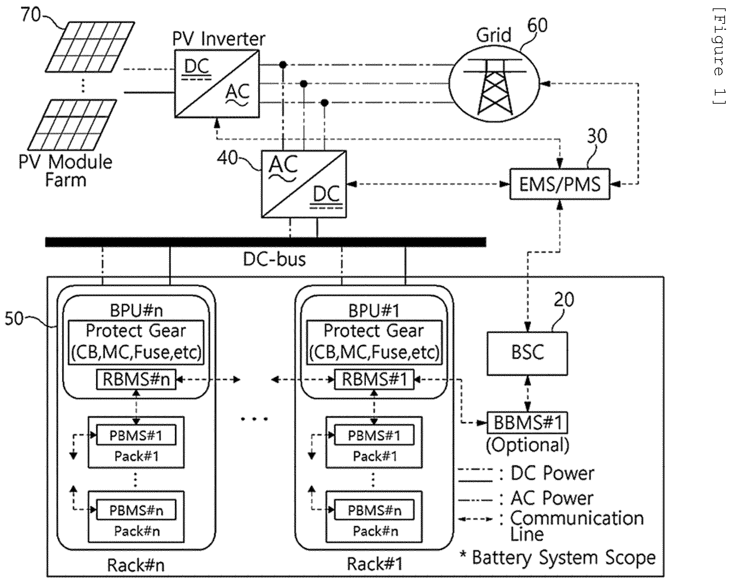

FIG. 1 is a block diagram of a general energy storage system.

Typically, a battery cell is a basic unit of battery for storing power in an energy storage system (ESS). A seris/parallel combination of battery cells may form a battery pack and a plurality of battery packs may form a battery rack. In other words, a battery rack as a series/parallel combination of battery packs may be a basic unit of a battery system. Here, a battery pack may be referred to as a battery module depending on a device or a system in which the battery is used.

Referring to FIG. 1, a battery rack may include a plurality of battery packs and a battery protection unit (BPU) 50 or protection device. A battery rack may be monitored and controlled through a rack battery management system (rack BMS). The RBMS may monitor a current, a voltage and a temperature of each battery rack to be managed, calculate a state Of charge (SOC) of the battery based on a monitoring result, and control charging and discharging.

Meanwhile, the BPU 50 is a device for protecting the battery from abnormal current and fault current in a battery rack. The BPU may include a main contactor MC, a fuse, a circuit breaker CB, or a disconnect switch DS. The BPU may control the battery system rack by rack by controlling the main contactor on/off according to control of the RBMS. The BPU may also protect the battery from short-circuit current by using a fuse when a short-circuit occurs. As such, a general battery system may be controlled through a protection device such as a BPU or a switch gear.

Meanwhile, a battery system controller (BSC) 20 may be installed to monitor and control objects such as a voltage, a current, a temperature, and a circuit breaker, in each battery section including a plurality of batteries, peripheral circuits, and devices. The battery system controller is a top-level controller of a bank-level battery system including a plurality of battery racks and is also used as a controller in a battery system with a multiple bank-level structure. Here, a bank-level battery system may each include a Bank BMS (BBMS), and the BBMS may monitor and control each rack by interfacing with the RBMSs of the battery racks managed by the battery system.

Furthermore, a power conversion system (PCS) 40 installed in each battery section controls charging and discharging of the battery by controlling power supplied from an external source and power supplied from the battery section to the external, and may include a DC/AC inverter. Meanwhile, if the ESS system is interfacing with a photovoltaic (PV; solar power generation system) module farm 70, a PV inverter may be included.

Meanwhile, the output of each BPU may be connected to the PCS 40 which is connected to a power grid 60, through a DC bus. In addition, an energy management system (EMS)/power management system (PMS) 30 may control the energy storage system in overall.

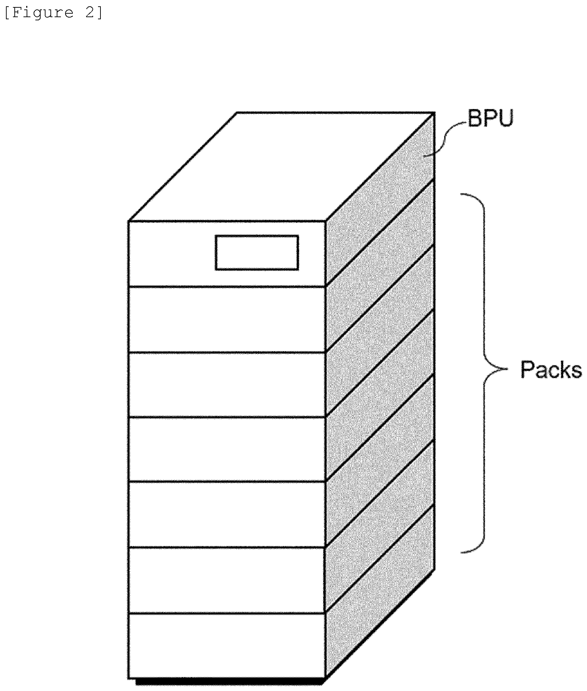

FIG. 2 illustrates a structure of a general battery rack.

The battery rack may include a battery protection unit (BPU) and a plurality of battery packs. The BPU and the plurality of battery packs may be connected in a vertically stacked structure.

The BPU, located at the top of the battery rack, may include a circuit breaker (CB) and a rack BMS (RBMS).

The RBMS may include a main contactor MC, a fuse, a microcontroller unit (MCU), memory, a power supply unit, and a current sensor.

Each of the battery packs positioned below the BPU may include a plurality of batteries and a pack battery management system (PBMS) that monitors and manages the batteries.

The batteries within each battery pack may be electrically connected in series and/or parallel and connected to power terminals provided in the BPU, thereby connecting to a direct current (DC) link.

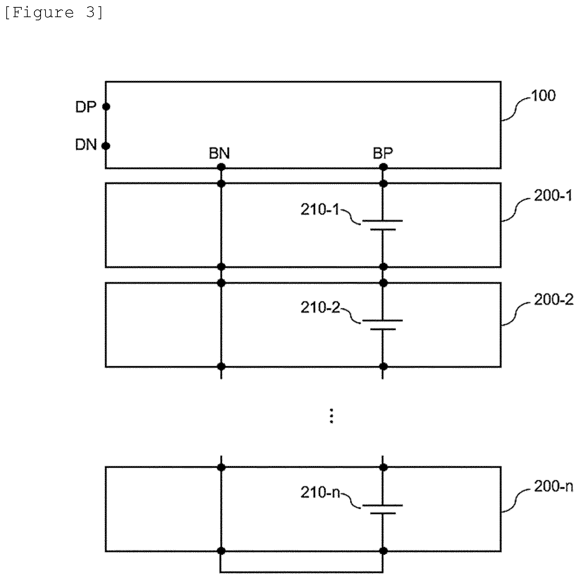

FIG. 3 is a block diagram of a battery system according to embodiments of the present invention.

Referring to FIG. 3, a battery system may include a battery protection device (BPU) 100 and a plurality of battery assemblies 200-1 to 200-n.

In the present disclosure, a battery assembly may refer to a battery pack, but the scope of the present invention is not limited to these entities. For example, a battery assembly may mean to a battery module, a battery rack, or a battery bank.

Each of the battery assemblies 200-1 to 200-n may include a plurality of batteries 210-1 to 210-n and a BMS that manages and controls the batteries. For example, a battery assembly may correspond to a battery pack and include a plurality of battery cells and a pack BMS (PBMS).

The plurality of batteries 210-1 to 210-n may be connected in series and/or parallel to form a set of batteries. The set of batteries may be connected to a charge/discharge terminal provided on the BPU 100 and electrically connected to a DC link.

For example, as illustrated in FIG. 3, a plurality of batteries 210-1 to 210-n may be connected in series with each other, and the battery positive terminal and battery negative terminal of the uppermost battery assembly (200-1) may be connected to the positive charge/discharge terminal BP and the negative charge/discharge terminal BN of the BPU 100, respectively. Here, the positive charge/discharge terminal BP and the negative charge/discharge terminal BN may be electrically connected to the positive DC link terminal DP and the negative DC link terminal DN, respectively, within the BPU 100. Accordingly, a set of batteries 210-1 to 210-n connected in series with each other may be connected to the DC link.

The BPU 100 may include a circuit breaker (CB) and a battery management apparatus (BMS) therein.

The battery management apparatus (BMS) may include a main contactor MC, a fuse, a control unit, a power supply unit, a power holding unit, and a current sensor.

The battery management apparatus may be an upper control apparatus of the BMS included in each of the battery assemblies 200-1 to 200-n. For example, the battery management apparatus included in the BPU may be a rack BMS (RBMS) that manages a plurality of battery packs.

The battery management apparatus may monitor and manage the battery assemblies 200-1 to 200-n.

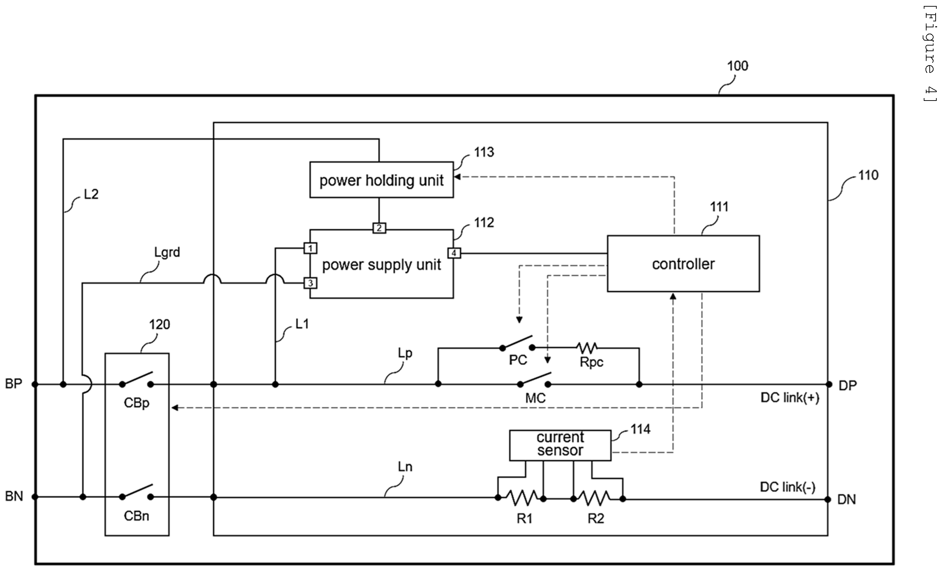

FIG. 4 is a circuit diagram of a battery protection device according to embodiments of the present invention.

Referring to FIG. 4, a plurality of terminals may be provided on the exterior surface of the battery protection device 100. Here, the terminals may include a positive charge/discharge terminal BP, a negative charge/discharge terminal BN, a positive DC link terminal DP, and a negative DC link terminal DN.

The positive charge/discharge terminal BP and the negative charge/discharge terminal BN may be connected to the positive and negative terminals of a set of batteries 210, respectively.

The positive charge/discharge terminal BP may be connected to the positive DC link terminal DP via a positive line Lp, and the negative charge/discharge terminal BN may be connected to the negative DC link terminal DN via a negative line Ln.

The battery protection device 100 may include a circuit breaker 120 and a battery management apparatus 110. Here, the battery management apparatus 110 may manage the battery assemblies and control the operation of the circuit breaker 120.

The circuit breaker 120 may be positioned on the battery's charge/discharge lines Lp, Ln. Here, the circuit breaker 120 may include a positive cutoff switch CBp positioned on the positive line Lp and a negative cutoff switch CBn positioned on the negative line Ln.

The controller 111 of the battery management apparatus 110 may monitor whether a predefined circuit breaker open event occurs, and the controller 111 may switch the circuit breaker from a closed state to an open state if a circuit breaker open event occurs. For example, if the current or temperature at a specific location within the battery system exceeds a threshold value, the controller 111 may switch both the positive cutoff switch CBp and the negative cutoff switch CBn to an open state, thereby disconnecting the electrical connection between the set of batteries and the DC link.

The battery management apparatus 110 may include a controller 111, a power supply unit 112, a power holding unit 113, a current sensor 114, a main contactor MC, and a pre-charge circuit (PC, Rpc).

The controller 111 may operate by receiving power from the power supply unit 112 and may control the operation of the circuit breaker 120, the power holding unit 113, the main contactor MC, and the pre-charge switch PC.

The main contactor MC may be positioned on the positive line Lp, and a pre-charge switch PC and a pre-charge resistor Rpc may be connected in parallel with the main contactor MC.

The controller 111 may control the electrical connection between the set of batteries and the DC link by on/off controlling the main contactor MC and the pre-charge switch PC.

The current sensor 114 may be configured to measure current flowing on the positive line Lp or the negative line Ln. For example, as illustrated in FIG. 4, a first shunt resistor R1 and a second shunt resistor R2 are arranged on the negative line Ln, and the current sensor 130 may measure the voltage across the first shunt resistor R1 and the voltage across the second shunt resistor R2 to calculate the current flowing through the first shunt resistor R1 and the second shunt resistor R2.

The power supply unit 112 may receive power from the battery and supply power to the controller 111.

The power holding unit 113 may receive power from the battery and temporarily supply power to the power supply unit 112 when the circuit breaker 120 is being open. Here, the power supply unit 112 may supply temporary power supplied from the power holding unit 113 to the controller 111.

The power supply unit 112 may receive power from the battery via the first power supply line L1 and supply power to the controller 111. Furthermore, the power holding unit 113 may receive power from the battery via the second power supply line L2 and supply temporary power to the power supply unit 112.

For example, referring to FIG. 4, the power supply unit 112 may include a first power input terminal 1, a second power input terminal 2, a ground terminal 3, and a first power output terminal 4.

One end of the first power supply line L1 may be connected between a positive cutoff switch CBp and a main contactor MC, and the other end of the first power supply line L1 may be connected to the first power input terminal 1 of the power supply unit 112.

Furthermore, one end of the second power supply line L2 may be connected between a positive charge/discharge terminal BP, which is an output terminal of the battery, and the positive cutoff switch CBp, and the other end of the second power supply line L2 may be connected to the second power input terminal 2 of the power supply unit 112.

The power holding unit 113 may be disposed on the second power supply line L2 and include a power holding switch therein. Here, the controller 111 may control whether to supply temporary power to the power supply unit 112 by on/off controlling the power holding switch.

One end of the ground line Lgrd may be connected to the negative charge/discharge terminal BN and the negative cutoff switch CBn, and the other end of the ground line Lgrd may be connected to the ground terminal 3 of the power supply unit 112.

The first power output terminal 4 of the power supply unit 112 may be electrically connected to the controller 111 and may convert power supplied through the first power supply line L1 or the second power supply line L2 to a set voltage and supply it to the controller 111.

When a predefined circuit breaker open event occurs, the controller 111 may control the power holding unit 113 to switch the second power supply line L2 to an activate state. For example, if the current or temperature at a specific location within the battery system exceeds a threshold value, the controller 111 may switch the power holding switch included in the power holding unit 113 from an open state to a closed state, thereby activating the second power supply line L2. Accordingly, power output from the battery may be supplied to the power supply unit 112 via the second power supply line L2.

When the second power supply line L2 is activated, the controller 111 may switch the circuit breaker 120 to an open state.

Thereafter, the controller 111 may deactivate the second power supply line L2 after a predetermined period of time has elapsed or a predetermined power-off sequence has been completed. For example, when 20 seconds have passed since the circuit breaker 120 has been switched to an open state, the controller 111 may switch the power holding switch from a closed state to an open state to cut off temporary power supplied to the power supply unit 112. As another example, when the circuit breaker 120 has been switched to an open state, the controller 111 may perform a power-off sequence, including a state check operation of internal components, a data storage operation, and an off-state switching operation of internal components. When the power-off sequence is completed, the controller 111 may switch the power holding switch from a closed state to an open state to cut off temporary power supplied to the power supply unit 112.

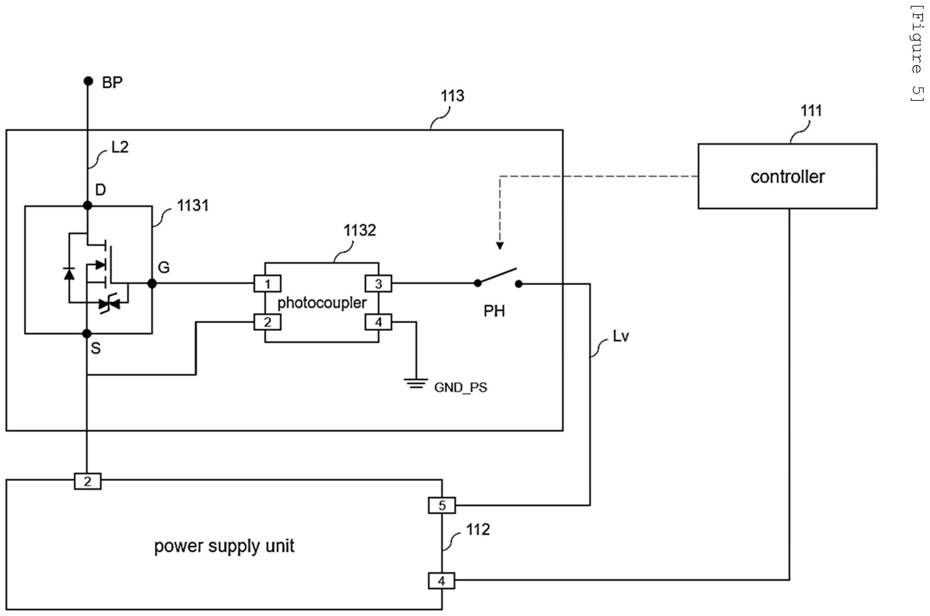

FIG. 5 is a circuit diagram of a power holding unit according to embodiments of the present invention.

Referring to FIG. 5, the power holding unit 113 may include a MOSFET 1131, a photocoupler 1132, and a voltage supply switch (PH).

The MOSFET 1131 is positioned on a second power supply line L2 and may be turned on and off under the control of the controller 111. Here, the second power supply line L2 may be activated when the MOSFET 1131 is switched on (closed state), and the second power supply line L2 may be deactivated when the MOSFET 1131 is switched off (open state). In other words, the MOSFET 1131 may correspond to a power holding switch.

The photocoupler 1132 may apply a gate voltage to the MOSFET 1131 under the control of the controller 111. When the gate voltage is applied to the MOSFET 1131, the MOSFET 1131 may be switched from an OFF state to an ON state.

The photocoupler 1132 may include a first output terminal 1, a second output terminal 2, a first input terminal 3, and a second input terminal 4.

A light-receiving element may be arranged between the first output terminal 1 and the second output terminal 2, and a light-emitting element may be arranged between the first input terminal 3 and the second input terminal 4.

The first output terminal 1 may be connected to the gate terminal of the MOSFET 1131, and the second output terminal 2 may be connected to the source terminal of the MOSFET 1131. In addition, the first input terminal 3 may be connected to the operation voltage supply line Lv, and the second input terminal 4 may be connected to the ground line Lgrd of the power supply unit 112.

One end of the operation voltage supply line Lv may be connected to the first input terminal 3 of the photocoupler 1132, and the other end of the operation voltage supply line Lv may be connected to the second power output terminal 5 of the power supply unit 112. In other words, the light-emitting element of the photocoupler 1132 may receive an operating voltage from the power supply unit 112 to emit light.

The voltage supply switch PH is positioned on the operation voltage supply line Lv and may be turned on/off by the controller 111.

When a predefined circuit breaker open event occurs, the controller 111 may switch the voltage supply switch PH from an open state to a closed state. Accordingly, the photocoupler 1132 applies a gate voltage to the MOSFET 1131, which switches from an off state to an on state, thereby switching the second power supply line L2 to an activated state. Accordingly, temporary power can be supplied to the power supply unit 112.

When the second power supply line L2 is activated, the controller 111 may switch the circuit breaker 120 to an open state.

Thereafter, when a predetermined period of time has elapsed or a predetermined power-off sequence is completed, the controller 111 may switch the voltage supply switch PH from a closed state to an open state, thereby switching the second power supply line L2 to an inactive state. Accordingly, the temporary power supplied to the power supply unit 112 can be cut off.

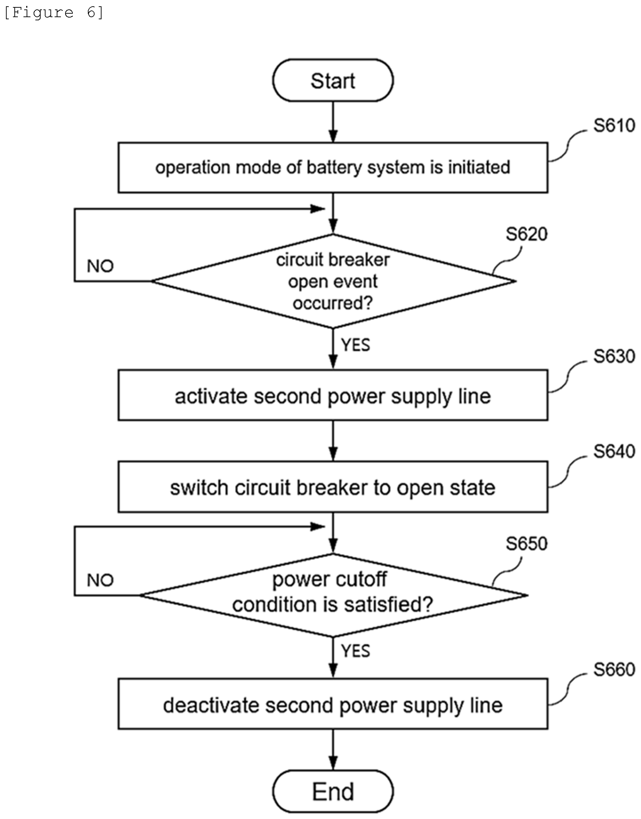

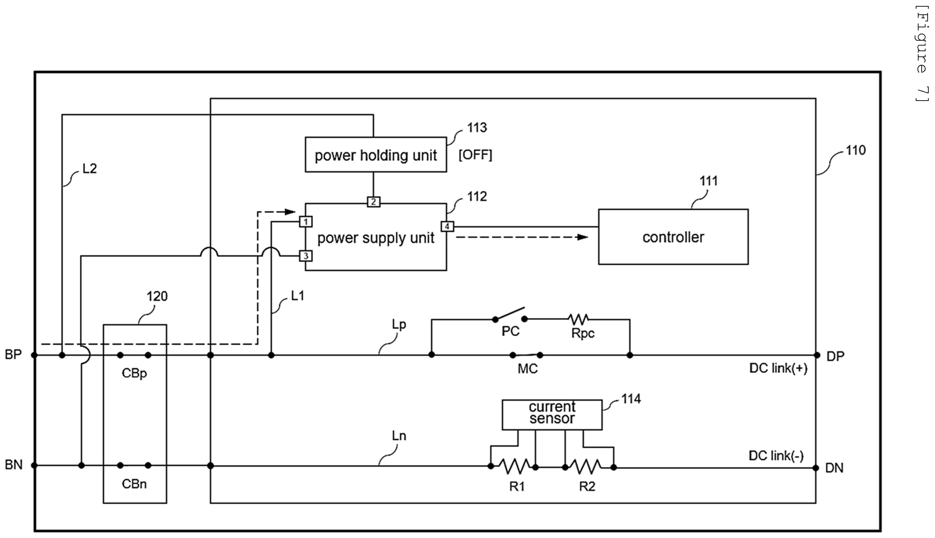

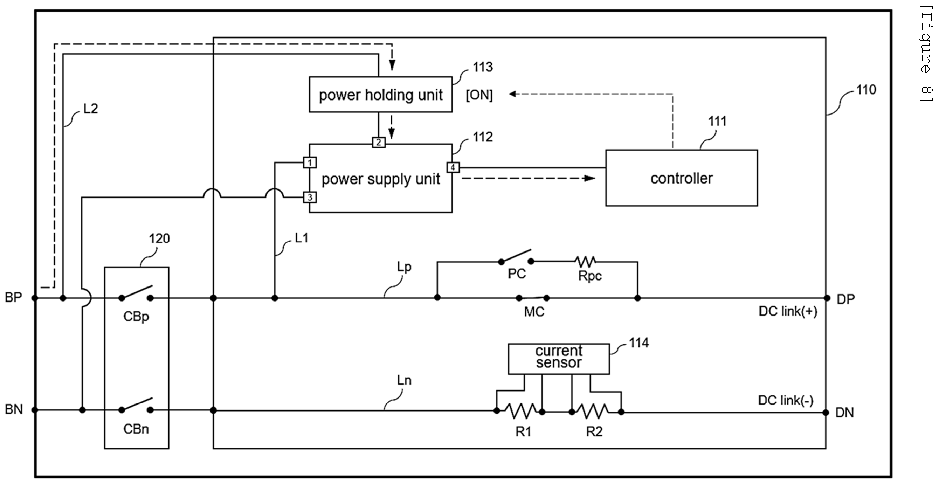

FIG. 6 is a flowchart illustrating an operation method of a battery system according to embodiments of the present invention, and FIGS. 7 and 8 are reference diagrams for explaining an operation method of a battery system according to embodiments of the present invention.

When an operation mode of the battery system is initiated (S610), the power supply unit 112 may receive power from the battery through the first power supply line L1, as illustrated in FIG. 7, and supply power to the controller 111. Here, the power holding switch included in the power holding device 113 may be maintained in an off state (open state), and thus, the second power supply line L2 can be maintained in an inactive state.

The controller 111 may monitor whether a predefined circuit breaker open event occurs (S620). For example, the controller 111 may collect battery state values from lower-level BMSs and determine whether a specific state value exceeds a predefined threshold value. If a specific state value exceeds a predefined threshold, the controller 111 may determine that a circuit breaker open event has occurred.

If a circuit breaker open event occurs (YES in S620), the controller 111 may control the power holding device 113 to switch the second power supply line L2 to an active state (S630).

Here, the controller 111 may switch the power holding switch located on the second power supply line L2 from an open state to a closed state, thereby switching the second power supply line L2 to an active state. For example, the controller 111 may switch the voltage supply switch (PH) illustrated in FIG. 5 from an open state to a closed state. Accordingly, the photocoupler 1132 applies a gate voltage to the MOSFET 1131, which switches from an off state to an on state, thereby switching the second power supply line L2 to an activated state. Accordingly, the power supply unit 112, as illustrated in FIG. 8, may receive power from the battery through the second power supply line L2 and supply power to the controller 111.

After the second power supply line L2 is activated, the controller 111 may switch the circuit breaker 120 located on a charge/discharge line of the battery to an open state (S640).

Thereafter, the controller 111 may determine whether a predefined power cutoff condition is satisfied (S650). Here, the power cutoff condition may include one or more of a first condition, in which a predefined period of time elapses after the circuit breaker 120 is switched open, and a second condition, in which a predefined power-off sequence is completed. For example, the controller 111 may determine whether 20 seconds have elapsed since the circuit breaker 120 was switched open, or whether the predefined power-off sequence has been fully executed after the circuit breaker 120 was switched open.

If the power cutoff condition is satisfied (YES in S650), the controller 111 may control the power holding unit 113 to deactivate the second power supply line L2 (S660). For example, the controller 111 may deactivate the second power supply line L2 by switching the voltage supply switch (PH) illustrated in FIG. 5 from a closed state to an open state. Accordingly, the temporary power supplied to the power supply unit 112 is cut off, and thus, the power supply to the controller 111 may also be interrupted.

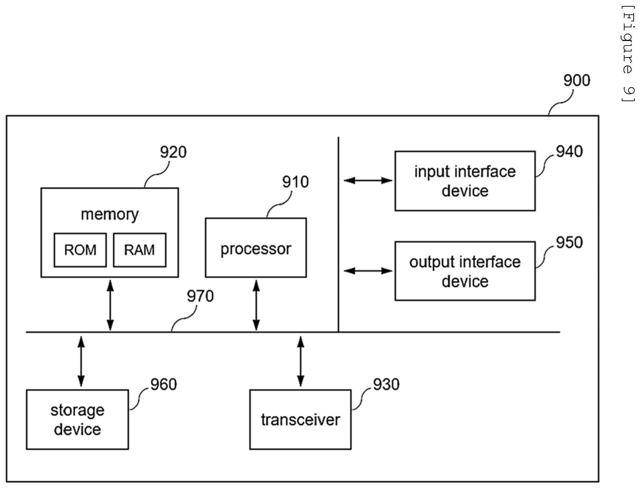

FIG. 9 is a block diagram of a controller according to embodiments of the present invention.

The controller 900 according to embodiments of the present invention may be included in a battery management apparatus positioned between a circuit breaker disposed on a battery charge/discharge line and a DC link.

Here, the battery management apparatus may include a power supply unit that receives power from the battery via a first power supply line and supplies power to the controller 900; and a power holding device that receives power from the battery via a second power supply line and temporarily supplies power to the power supply unit.

The controller 900 may include at least one processor 910, a memory 920 that stores at least one instruction executed by the processor, and a transceiver 930 that is connected to a network and performs communication.

The at least one instruction may include an instruction to monitor whether a predefined circuit breaker open event occurs; an instruction to control the power holding device to switch the second power supply line from a deactivated state to an activated state upon the occurrence of the circuit breaker open event; and an instruction to open a circuit breaker disposed on the battery's charge/discharge line after the second power supply line is activated.

The at least one instruction may further include an instruction to deactivate the second power supply line, if a predetermined period of time has elapsed or a predetermined power-off sequence has been completed after the circuit breaker is switched to an open state.

The instruction to activate the second power supply line from the deactivated state may include an instruction to activate the second power supply line by switching a power holding switch disposed on the second power supply line from an open state to a closed state.

The power holding device may include a MOSFET disposed on the second power supply line; a photocoupler that applies a gate voltage to the MOSFET; and a voltage supply switch disposed on a path that supplies an operating voltage to the photocoupler. Here, the instruction to activate the second power supply line from the deactivated state may include an instruction to activate the second power supply line by switching the voltage supply switch from an open state to a closed state.

The controller 900 may further include an input interface device 940, an output interface device 950, a storage device 960, etc. Respective components included in the controller 900 may be connected to each other by a bus 970 and communicate with each other.

Here, the processor 910 may mean a central processing unit (CPU), a graphics processing unit (GPU), or a dedicated processor on which methods according to embodiments of the present invention are performed. Furthermore, the memory may include at least one of a volatile/transitory storage medium and a nonvolatile/non-transitory storage medium. For example, the memory may include at least one of a read-only memory (ROM) and a random access memory (RAM), and may include an Electrically Erasable Programmable Read-only Memory (EEPROM).

The operations of the method according to the embodiments of the present invention may be implemented as a computer-readable program or code on a computer-readable recording medium. The computer-readable recording medium includes all types of recording devices in which data readable by a computer system is stored. In addition, the computer-readable recording medium may be distributed in a network-connected computer system to store and execute computer-readable programs or codes in a distributed manner.

The operations of the method according to embodiments of the present invention may be implemented in various forms related to programs, such as a computer program or code itself, or a computer program product.

Furthermore, the computer-readable recording medium may include one or more of a volatile/transitory recording medium and a non-volatile/non-transitory recording medium.

In addition, the computer-readable recording medium may include hardware devices specially configured to store and execute program instructions, such as ROM, RAM, flash memory, and may include, for example, various types of servers located on a network. The program instructions may include not only machine language codes, such as those created by a compiler, but also high-level language codes that can be executed by a computer using an interpreter.

Although some aspects of the invention have been described in the context of the apparatus, it may also represent a description according to a corresponding method, wherein a block or apparatus corresponds to a method step or feature of a method step. Similarly, aspects described in the context of a method may also represent a feature of a corresponding block or item or a corresponding apparatus. Some or all of the method steps may be performed by (or using) a hardware device, such as, for example, a microprocessor, a programmable computer, or an electronic circuit. In some embodiments, one or more of the most important method steps may be performed by such an apparatus.

In the forgoing, the present invention has been described with reference to the exemplary embodiment of the present invention, but those skilled in the art may appreciate that the present invention may be variously corrected and changed within the range without departing from the spirit and the area of the present invention described in the appending claims.

## Claims

1. A battery system comprising:
a battery;
a circuit breaker located on a charge/discharge line of the battery; and
a battery management apparatus configured to manage the battery and control the operation of the circuit breaker,
wherein the battery management apparatus includes:
a controller;
a power supply unit configured to receive power from the battery through a first power supply line and supply power to the controller; and
a power holding device configured to receive power from the battery through a second power supply line and to supply temporary power to the power supply unit in a state that the circuit breaker is open.

2. The battery system of claim 1, wherein the controller controls the power holding device to activate the second power supply line upon a predefined circuit breaker open event occurring.

3. The battery system of claim 2, wherein the controller switches the circuit breaker to an open state after the second power supply line is activated and switches the second power supply line to an inactive state when a predetermined period of time has elapsed or a predetermined power-off sequence has been completed.

4. The battery system of claim 1, wherein the first power supply line has one end connected between the circuit breaker and a main contactor positioned on the charge/discharge line and the other end connected to a first power input terminal of the power supply unit.

5. The battery system of claim 4, wherein the second power supply line has one end connected between an output terminal of the battery and the circuit breaker and the other end connected to a second power input terminal of the power supply unit.

6. The battery system of claim 1, wherein the power holding device includes a power holding switch disposed on the second power supply line, and
wherein the controller switches the power holding switch from an open state to a closed state when a predefined circuit breaker open event occurs, thereby switching the second power supply line to an activated state.

7. The battery system of claim 1, wherein the power holding device includes:
a MOSFET disposed on the second power supply line;
a photocoupler that applies a gate voltage to the MOSFET; and
a voltage supply switch disposed on a path that supplies an operating voltage to the photocoupler, and
wherein the controller switches the voltage supply switch from an open state to a closed state when a predefined circuit breaker open event occurs, thereby switching the second power supply line to an activated state.

8. The battery system of claim 7, wherein the photocoupler receives the operating voltage from the power supply unit.

9. A method of operating a battery system, by a battery management apparatus including a controller; a power supply unit configured to receive power from a battery through a first power supply line and supply power to the controller; and a power holding device configured to receive power from the battery through a second power supply line and supply temporary power to the power supply unit, the method comprising:
monitoring whether a predefined circuit breaker open event occurs;
controlling the power holding device to switch the second power supply line from a deactivated state to an activated state if the circuit breaker open event occurs; and
switching a circuit breaker disposed on a charge/discharge line of the battery to an open state after the second power supply line is activated.

10. The method of claim 9, further comprising:
switching the second power supply line to a deactivated state if a predetermined period of time has elapsed or a predetermined power-off sequence has been completed after the circuit breaker is switched to an open state.

11. The method of claim 9, wherein the switching of the second power supply line from a deactivated state to an activated state includes:
switching a power holding switch disposed on the second power supply line from an open state to a closed state, thereby switching the second power supply line to an activated state.

12. The method of claim 9, wherein the power holding device includes:
a MOSFET disposed on the second power supply line;
a photocoupler that applies a gate voltage to the MOSFET; and
a voltage supply switch disposed on a path that supplies an operating voltage to the photocoupler, and
wherein the switching of the second power supply line from a deactivated state to an activated state includes:
switching the voltage supply switch from an open state to a closed state, thereby switching the second power supply line to an activated state.

13. A battery management apparatus, positioned between a circuit breaker disposed on a battery charge/discharge line and a DC link, the apparatus comprising:
a controller;
a power supply unit configured to receive power from the battery through a first power supply line and supply power to the controller; and
a power holding device configured to receive power from the battery through a second power supply line and to supply temporary power to the power supply unit in a state that the circuit breaker is open.

14. A computer-readable medium having recorded thereon a program for executing the method of any one of claims 9 to 12 on a computer.
